Europäisches Patentamt

European Patent Office

Office européen des brevets

(11) Numéro de publication: **0 231 700**
**A1**

## (12) DEMANDE DE BREVET EUROPEEN

(21) Numéro de dépôt: 86402866.7

(22) Date de dépôt: 19.12.86

(51) Int. Cl.4: **H01L 29/93**

(30) Priorité: 31.12.85 FR 8519494

(43) Date de publication de la demande:
12.08.87 Bulletin 87/33

(84) Etats contractants désignés:
**DE GB IT NL**

(71) Demandeur: **THOMSON-CSF**
**173, Boulevard Haussmann**
**F-75379 Paris Cedex 08(FR)**

(72) Inventeur: **Pavlidis, Dimitrios**
**SCPI 19, avenue de Messine**
**F-75008 Paris(FR)**
Inventeur: **Archambault, Yves**
**SCPI 19, avenue de Messine**
**F-75008 Paris(FR)**
Inventeur: **Karapiperis, Léonidas**
**SCPI 19, avenue de Messine**
**F-75008 Paris(FR)**

(74) Mandataire: **Taboureau, James et al**
**THOMSON-CSF SCPI 19, avenue de Messine**
**F-75008 Paris(FR)**

(54) **Diode à capacité variable, à profil hyperabrupt, et structure plane, et son procédé de réalisation.**

(57) L'invention concerne une diode à capacité variable de structure plane.

Pour pouvoir être réalisée en circuit intégré, cette diode comporte, sur un substrat (6), trois régions (7,8,9) coplanaires. Les première (7) et deuxième (9) régions, uniformément dopées, supportent les métallisations de prises de contacts (10, 11). La région de transition (8) présente une variation de niveau de dopage ($\Delta n$), faible à une extrémité (12) et élevée à l'autre extrémité (13). Cette variation ($\Delta n$) est obtenue par implantation par faisceau d'ions focalisés, à énergie constante et balayage à doses croissantes, ce qui permet de réaliser un profil hyperabrupt. La diode est à jonctions p-n ou à contact Schottky.

Application aux circuits intégrés, ou aux composants discrets, sur silicium ou matériaux III-V, tel que GaAs.

FIG.2

# DIODE A CAPACITE VARIABLE, A PROFIL HYPERABRUPT ET STRUCTURE PLANE, ET SON PROCEDE DE REALISATION

La présente invention concerne une diode, de structure plane, à capacité variable, à profil abrupt, dont la loi de variation de la capacité en fonction de la tension de commande peut être quelconque, étant donné qu'elle est une conséquence de la structure plane de la diode, et du profil du niveau de dopage de la couche superficielle de matériau semiconducteur, ce profil étant obtenu par un procédé d'implantation d'ions.

La diode selon l'invention peut être réalisée aussi bien sur silicium que sur les matériaux du groupe III-V tel que GaAs. De même, elle peut être réalisée sous forme de composant discret, encapsulé dans un boitier ou monté à plat avec connexions par poutres (beam leads), ou de composant intégré dans un circuit intégré, basse fréquence ou hyperfréquence..

Les diodes à capacité variable connues sont réalisées par implantation d'ions ou par épitaxie de couches successives : elles ont une structure vericale. Mais il n'est pas possible de réaliser un profil hyperabrupt par implantation dans une structure verticale, en raison des variations du dopage obtenu par implantation. Ce n'est possible que par épitaxie, mais l'épitaxie n'est pas applicable dans ce cas aux circuits intégrés : on ne peut pas, sur une plaquette de matériau semiconducteur, n'épitaxier qu'à l'emplacement des diodes à capacité variable, et pas ailleurs. Ou alors cela nécessite une technologie compliquée et délicate.

Pour pouvoir réaliser une diode à capacité variable à profil hyperabrupt intégrée, la base de l'invention consiste à développer ce profil en surface de la plaquette, dans une structure plane, et non plus en profondeur, dans une structure verticale. Le profil de dopage désiré est obtenu par implantation d'ions, dans une zone de transition entre les métallisations de prise de contact coplanaires sur une même face de la plaquette de matériau semiconducteur.

De façon plus précise l'invention concerne une diode à capacité variable, à profil hyperabrupt et de structure plane, comportant, supportées par un substrat en matériau semiconducteur, une première région d'accès fortement dopée de type n+ et sur laquelle est déposée une première métallisation de prise de contact, et une seconde région d'accès fortement dopée et sur laquelle est déposée une seconde métallisation de prise de contact, cette diode étant caractérisée en ce que la région située entre les deux régions d'accès et coplanaire avec elles constitue une région de transition, dont le niveau de dopage évolue depuis une valeur faible, à proximité de la première région, jusqu'à une valeur élevée à proximité de la deuxième région.

L'invention sera mieux comprise par la description d'un exemple d'application, s'appuyant sur les figures jointes en annexes, qui représentent :

-Figure 1 : profil de dopage d'une diode à capacité variable selon l'art connu, dont la structure est superposée au profil,

-Figure 2 : vue en coupe d'une diode à jonction n-p selon l'invention,

-Figure 3 : profil de dopage d'une diode à capacité variable selon l'invention,

-Figure 4 : profils de dopage des différentes régions de la diode de la figure 2,

-Figure 5 : vue en coupe d'une diode Schottky, selon l'invention.

Les diodes à capacité variable ont de nombreuses applications telles que l'accord électronique des oscillateurs, la détection, le mélange ou la génération d'harmoniques des signaux. L'une de leurs caractéristiques est que leur capacité varie en fonction inverse de la tension de polarisation V qui leur est appliquée, selon l'expression :

$$C \propto \frac{1}{(V+\Phi)^k}$$

dans laquelle :

-$\Phi$ est la hauteur de barrière Schottky

-$k = 1/(m+2)$, le paramètre définissant la variation de dopage n en fonction de la distance d, par rapport à la surface selon :

$n \propto d^m$

La capacité d'une diode à capacité variable est donc liée au paramètre m, pour une tension de polarisation donnée.

On distingue différents cas de distribution des porteurs de charges :

si m = 1, la diode est à profil à pente linéaire,

si m = 0, la diode est à profil abrupt,

si m = -1 ou -3/2, la diode est à profil hyperabrupt.

Il est très important de pouvoir contrôler la valeur du paramètre pour obtenir un fonctionnement optimal et une sensibilité maximale, avec linéarité de réponse en fréquence.

Dans les diodes connues, à structure verticale, la réalisation d'un profil hyperabrupt n'est possible que par des méthodes d'épitaxie, qui ne sont pas applicables pour obtenir cet effet aux circuits intégrés.

En effet, bien qu'on connaisse des diodes à structure plane c'est à dire ayant les métallisations de prises de contacts complémentaires, mais présentant une jonction en profondeur, il est impossible de réaliser par implantation des profils hyperabrupts ou à pente linéaire, parce que le paramètre m dépend de la distribution gaussienne n-(d) de l'implantation utilisée.

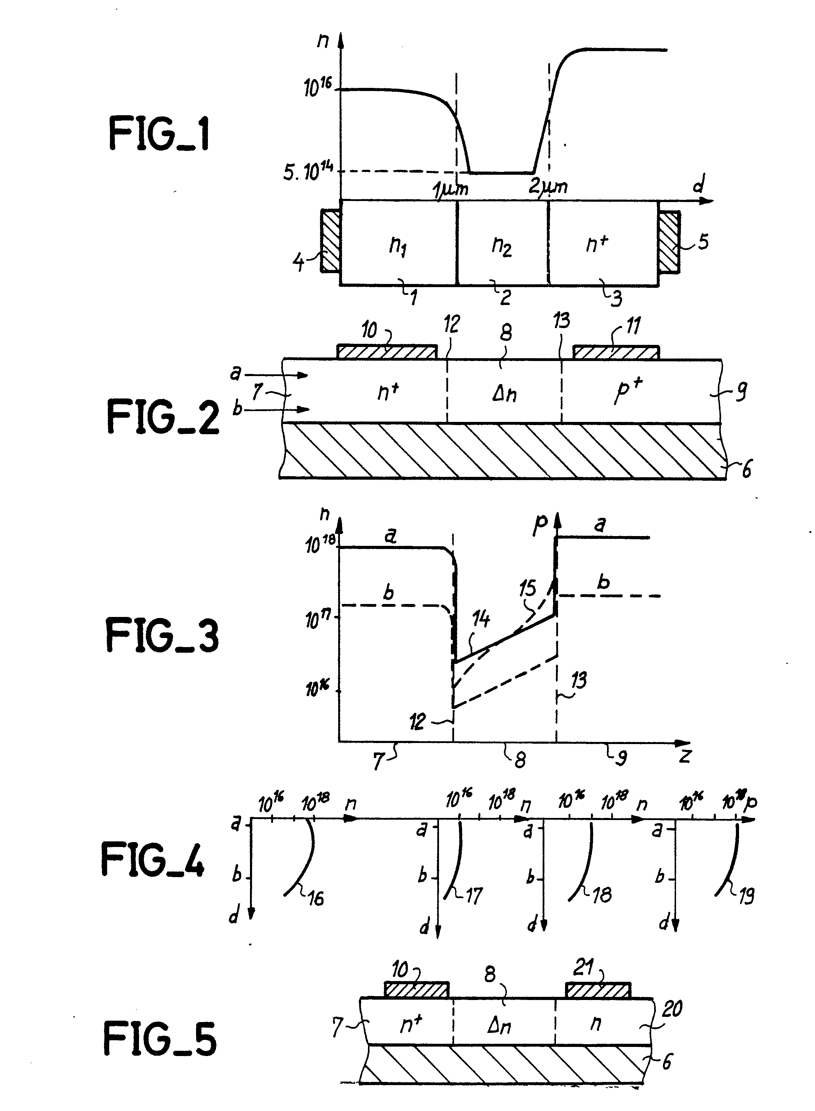

Un exemple de diode à structure verticale, connue, est illustré par la figure 1.

Deux couches de matériau semiconducteur 1 et 2 sont déposées et/ou épitaxiées sur un substrat 3 : la couche 1 est fortement dopée, au niveau $n_1$ et la couche 2 est faiblement dopée au niveau $n_2$, le substrat 3 étant par exemple fortement dopé $n^+$ pour assurer une faible résistance au passage du courant entre les métallisations 4 et 5.

La jonction $n_1/n_2$ donne la caractéristique hyperabrupte à cette diode. Le profil hyperabrupt est représenté dans la partie supérieure de la figure : pour avoir une transition brutale depuis un niveau $10^{16}$ ions.cm$^{-3}$ jusqu'à un niveau de l'ordre de $5.10^{14}$ ions.c m$^{-3}$, à titre d'exemple, sur quelques angströms d'épaisseur d, seule l'épitaxie d'une couche $n_1$ sur une couche $n_2$ déjà existante est possible. L'implantation d'ions donnerait un profil beaucoup plus diffus.

La solution apportée par l'invention est représentée en figures 2 et 3.

Selon la figure 2, une diode à capacité variable est développée horizontalement, selon une structure plane. Un substrat 6, qui peut être semi-isolant s'il s'agit d'un circuit intégré GaAs, supporte une couche 7 + 8 + 9 de matériau semiconducteur.

Dans cette couche, la région 8 est fortement dopée de type $n^+$ à $10^{18}$ ions.cm$^{-3}$ et supporte une métallisation 10 de prise de contact. La région 9 est fortement dopée de type $p^+$, au même niveau $10^{18}$ ions.cm$^{-3}$ et supporte une seconde métallisation 11 de prise de contact. La diode de la figure 2 est une diode à jonction p-n et les deux métallisations sont ohmiques.

Mais la région 8 est une région de transition dont le niveau de dopage de type n évolue depuis une valeur relativement faible à proximité (12) de la région 7 jusqu'à une valeur relativement élevée à proximité (13) de la région 9, ou de la jonction $p^+$-n : cette transition du niveau de dopage est symbolisée par $\Delta n$.

Les courbes représentatives des niveaux de dopage sont données en figure 3, dont l'abscisse correspond aux longueurs $\ell$ entre anode et cathode -et non plus aux profondeurs d comme en figure 1-et dont les ordonnées correspondent aux niveaux de dopage n ou p selon les régions de la couche 7 + 8 + 9. La courbe "a", en trait plein, donne les niveaux de dopage à une profondeur "a", proche de la surface, sur la figure 2, et la courbe "b", en pointillés, donne ces niveaux à une profondeur "b" proche du substrat.

En surface (courbe "a"), les régions 7 et 9 de prises de contacts sont dopées à environ $10^{18}$ ions.cm$^{-3}$, de façon sensiblement constante. La région de transition 8 est inscrite entre deux profils hyperabrupts 12 et 13, et son niveau de dopage peut évoluer de plusieurs façons. Soit il évolue linéairement, selon la droite 14 en trait plein, depuis environ $10^{15}$ ions.cm$^{-3}$ jusque environ $10^{16}$-$10^{17}$ ions.cm$^{-3}$. Soit il évolue selon une loi quelconque, imposée par l'usage de la diode, et représentée par la courbe 15, en trait pointillé.

La transition des niveaux de dopage $\Delta n$, dans la région de transition 8, est facilement obtenue par la méthode d'implantation ionique à faisceau focalisé. On sait que cette méthode permet d'implanter des ions par balayage selon des bandes, parallèles entre elles, aussi fines que 1000 angströms. Il est donc possible d'implanter dans la région de transition 8 par balayage de bandes, selon une énergie constante, mais à des doses croissantes pour faire croître le niveau de dopage. La précision de ce type d'implantation, due à la finesse du faisceau, permet de réaliser des profils hyperabrupts, en 12 et 13.

La réalisation d'une diode selon l'invention est assez simple. A partir d'un substrat nu 6, des ions de Si ou Se sont implantés pour créer une région 7, dopée de type $n^+$ à $10^{18}$ ions.cm$^{-3}$ par exemple. Puis, sans changer d'ions d'implantation, la région de transition 8 est créée, par balayage du faisceau d'ions focalisés, parallèlement aux futures métallisations de prises de contacts. Le balayage a lieu sous énergie constante, de l'ordre de 150 KeV, mais à des doses croissantes de $5.10^{11}$ ions.cm$^{-2}$ à $5.10^{13}$ ions.cm$^{-2}$, de façon à obtenir une transition de niveau de dopage, faible dans la région du profil 12, élevé dans la région du profil 13 qui constitue la jonction $p^+$-$n^+$: la dose implantée commandera la loi de variation du niveau de dopage, linéaire ou quelconque, selon les courbes 14 et 15 de la figure 3.

Enfin, par implantation d'ions de Be, Zn, Zn + As etc..., la région 9 est dopée de type $p^+$.

La figure 4 donne les différents niveaux de dopage des régions de la diode selon l'invention. Sur un axe commun d'ordonnées, horizontal, sont portées les échelles de dopage, n ou p. Les axes d'abscisses, verticaux, correspondent aux profondeurs d'implantation : les quatre courbes représentées sont à rapprocher de la diode de la figure 2. Les courbes 16 et 19 correspondent aux régions 7 et 9 de prises de contacts, dopées n+ et p+ respectivement. Les courbes 17 et 18 correspondent aux deux extrémités 12 et 13 de la région de transition 8.

L'allure de ces courbes s'explique par le fait que le taux d'implantation diminue lorsque la distance d par rapport à la surface implantée augmente. C'est ce qui explique les différences de niveaux d'implantation entre les courbes "a" et "b" de la figure 3.

La diode selon l'invention peut également être réalisée sous forme d'une diode Schottky : elle est représentée en figure 5.

Dans ce cas, la diode Schottky diffère de la diode à jonction p-n précédemment décrite en ce que :
-la région 9 de type p+ est remplacée par une région 20 de type n
-le contact ohmique 11 est remplacé par un contact Schottky 21
-le processus de fabrication est modifié en conséquence, avec implantation d'ions de Si ou Se pour créer une région n 20, et dépôt de métaux tels que Ti, Al etc... pour créer un contact Schottky 21.

De façon générale, pour les deux types de diodes, à jonction ou Schottky, la résistance d'accès entre le contact ohmique 10 et la région de transition 8 dépend peu de la tension de commande, puisqu'elle n'est plus liée à la zone déplétée comme dans les diodes conventionnelles. Pour une capacité de 1pF, les résistances d'accès des diodes proposées sont de quelques dizièmes d'ohms, par opposition aux quelques ohms dans les diodes classiques.

Par contre, la structure de la diode de l'invention étant plane, le courant passe dans l'épaisseur de la couche $7+8+9$ : la surface effective de la jonction p-n est réduite, dans le sens de l'épaisseur de cette couche, à quelques 1000 angströms. Ceci nécessite donc d'avoir des contacts métalliques plus longs, de façon à rétablir une surface de jonction suffisante pour obtenir une même capacité qu'avec une diode classique.

Cette diode a été étudiée pour être réalisée sous forme intégrée, dans un circuit intégré. Mais sa structure permet de la fabriquer également sous forme de composant discret. Si elle est réalisée en silicium plutôt qu'en GaAs, les ions de dopage sont bien entendu modifiés, selon les technologies connues de l'homme de l'art.

Elle est précisée par les revendications suivantes.

## Revendications

1. Diode à capacité variable, à profil hyperabrupt et de structure plane, comportant, supportées par un substrat (6) en matériau semiconducteur, une première région d'accès (7) fortement dopée de type n+ et sur laquelle est déposée une première métallisation (10) de prise de contact, et une seconde région d'accès (9) fortement dopée et sur laquelle est déposée une seconde métallisation - (11) de prise de contact, cette diode étant caractérisée en ce que la région (8) située entre les deux régions d'accès (7, 9) et coplanaire avec elles constitue une région de transition, dont le niveau de dopage ($\Delta$n) évolue depuis une valeur faible, à proximité (12) de la première région (7), jusqu'à une valeur élevée à proximité (13) de la deuxième région (9).

2. Diode à capacité variable selon la revendication 1, caractérisée en ce que la variation de niveau de dopage ($\Delta$n) dans la région de transition (8) suit une loi de profil linéaire (14).

3. Diode à capacité variable selon la revendication 1, caractérisée en ce que la variation de niveau de dopage ($\Delta$n) dans la région de transition (8) suit une loi de profil non-linéaire (15).

4. Diode à capacité variable selon la revendication 1, caractérisée en ce que la seconde région d'accès est dopée de type p+ (9), et en ce que les deux métallisations (10, 11) sont à contact ohmique, la diode étant de type à jonction.

5. Diode à capacité variable selon la revendication 1, caractérisée en ce que la seconde région d'accès est dopée de type n (20), et en ce que la première métallisation (10) est à contact ohmique et la seconde métallisation est à contact Schottky - (21), la diode étant de type Schottky.

6. Diode à capacité variable selon la revendication 1, caractérisé en ce que la région de transition (8) est dopée de type n à environ $10^{15}$ ions.cm$^{-3}$ à son extrémité la moins dopée (12) et à environ $10^{15}$-$10^{17}$ ions.cm$^{-3}$ à son extrémité la plus dopée (13).

7. Procédé de réalisation d'une diode à capacité variable selon l'une quelconque des revendications précédentes, caractérisée en ce que la région de transition (8) est obtenue par implantation d'ions à faisceau focalisé, sous énergie constante, et balayage à doses croissantes depuis $5.10^{11}$ ions.cm$^{-2}$ à l'extrémité la moins dopée (12) jusque $5.10^{13}$ions.cm$^{-2}$ à l'extrémité la plus dopée (13).

8. Procédé de réalisation d'une diode à capacité variable selon la revendication 7, caractérisé en ce qu'il concerne au moins une diode intégrée dans un circuit intégré.

0 231 700

FIG_1

FIG_2

FIG_3

FIG_4

FIG_5

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | US-A-3 636 420 (VENDELIN et al.) <br> * Colonne 2, lignes 37-60; figures 2L,4 * <br> --- | 1,4 | H 01 L 29/93 |
| A | FR-A-2 374 744 (THOMSON-CSF) <br> * Page 2, ligne 31 - page 3, ligne 8; figure 7 * <br> --- | 1,4 | |
| A | US-A-4 226 648 (GOODWIN et al.) <br> * Résumé; figures 1,2 * <br> --- | 1-4 | |
| A | US-A-3 706 128 (HEER) <br> * Résumé * | 1,5 | |
| | ----- | | |

DOMAINES TECHNIQUES RECHERCHES (Int. Cl.4)

H 01 L

Le présent rapport de recherche a été établi pour toutes les revendications

| Lieu de la recherche | Date d'achèvement de la recherche | Examinateur |
|---|---|---|
| LA HAYE | 03-04-1987 | BAILLET B.J.R. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503 03 82